# EUROPÄISCHE PATENTSCHRIFT

(11) **EP 0 492 110 B1**
(45) Veröffentlichungstag und Bekanntmachung des Hinweises auf die Patenterteilung: **08.02.1995**
(21) Anmeldenummer: 91119220.1
(22) Anmeldetag: 12.11.1991
(51) Int. Cl.: H05K 3/34, B60T 8/36, H05K 13/04

(54) **Verfahren zum Fügen einer Leiterbahnfolie mit einem elektrischen Bauteil, damit erzeugbares Gerät sowie Vorrichtung zum Montieren einer Leiterbahnfolie**
Method for connecting a flexible printed circuit board to an electrical component, apparatus obtainable thereby as well as a device for assembling a flexible printed circuit board
Méthode de connexion d'une plaquette à circuit imprimé flexible à un composant électrique, appareil susceptible d'être obtenue par cette méthode et dispositif de montage d'une plaquette à circuit imprimé flexible

(30) Priorität: 22.12.1990 DE 4041507
(43) Veröffentlichungstag der Anmeldung: 01.07.1992
(73) Patentinhaber: ROBERT BOSCH GMBH, 70442 Stuttgart (DE)
(72) Erfinder: Deringer, Helmut, Dipl.-Ing. (FH), W-7000 Stuttgart 40 (DE); Stade, Horst, Dipl.-Ing. (FH), W-8976 Blaichach (DE)

(56) Entgegenhaltungen:
- EP-A- 0 303 485
- EP-A- 0 348 311
- WO-A-89/10286
- DE-A- 3 836 405
- FR-A- 1 388 425
- FR-A- 1 440 481
- GB-A- 2 041 663
- GB-A- 2 179 884

## Beschreibung

### Stand der Technik

Die Erfindung geht aus von einem Verfahren zum Fügen einer Leiterbahnfolie aus einer zwischen Isolierschichten eingebetteten Leiterschicht mit wenigstens einem Kontaktstifte aufweisenden elektrischen Bauteil nach der Gattung des Patentanspruchs 1. Die Erfindung betrifft außerdem ein Gerät, welches nach dem Verfahren nach Anspruch 1 gefügt ist. Ferner betrifft die Erfindung auch eine Vorrichtung zur Anwendung des Verfahrens nach Anspruch 1.

Aus Gründen kostengünstiger Fertigung wird angestrebt, Einzelteile mit möglichst großen Toleranzen zu fertigen und zu Baugruppen oder Geräten zu fügen. Schwierigkeiten ergeben sich jedoch, wenn erhebliche Lagetoleranzen aufweisende Kontaktstifte elektrischer Bauteile mit den Lötaugen flexibler Leiterbahnfolien kombiniert werden sollen, weil diese von den Kontaktstiften ausgeübte Kräfte nicht aufnehmen können. Außerdem ist das Lot nicht in der Lage, mehrere Millimeter breite Spalte zwischen dem Kontaktstift und dem Stanzloch des Lötauges zu überbrücken. Darüber hinaus nimmt die Festigkeit einer Lötverbindung mit zunehmender Spaltbreite ab.

Es ist schon in DE-A-40 26 722 vorgeschlagen worden, auf die Kontaktstifte des elektrischen Bauteils je eine Scheibe aufzustecken, an welcher das entsprechende, ein relativ großes Stanzloch aufweisende Lötauge der Leiterbahnfolie abgestützt wird. Anschließend wird eine den jeweiligen Kontaktstift, das zugeordnete Lötauge und den innerhalb des Lötauges liegenden Bereich der Scheibe erfassende Benetzung mit Lot erzeugt, um eine sichere elektrische und mechanische Verbindung zu erzielen. Dabei dient die Scheibe als Träger für die Leiterbahnfolie sowie als Mittler zwischen Kontaktstift und Lötauge. Allerdings sind bei diesem Fügeverfahren Maßnahmen zum Lagesichern der Scheiben auf den Kontaktstiften sowie der Leiterbahnfolie auf den Scheiben erforderlich, bis die Lötverbindung erzeugt ist.

Außerdem ist aus FR-A-1 440 481 ein Verfahren zum Verbinden von Kontaktstifte aufweisenden Bauteilen mit einer Leiterplatte bekannt. Hierzu werden die Bauteile lagerichtig in einem Werkzeug aufgenommen, so daß sich die Kontaktstifte rechtwinklig zur Montageebene frei nach oben erstrecken. Die am Werkzeug aufgesetzte und mit Zentrierstiften geführte Leiterplatte wird auf die Bauteile abgesenkt, wobei die Kontaktstifte in einem vorangegangenen Arbeitsschritt vorbereitete Bohrungen der Leiterplatte durchdringen. Anschließend werden die Kontaktstifte durch Löten mit der Leiterplatte verbunden.

### Vorteile der Erfindung

Das erfindungsgemäße Verfahren mit den kennzeichnenden Verfahrensschritten nach Anspruch 1 hat demgegenüber den Vorteil, daß bereits vor dem Herstellen der Lötung eine form- und kraftschlüssige Verbindung der flexiblen Leiterbahnfolie mit den Kontaktstiften erzeugt wird, welche die Folie vor dem Trennen von den Stiften schützt. Von Vorteil ist außerdem das praktisch spaltfreie Angrenzen der Leitschicht an den jeweiligen Kontaktstift. Von ganz besonderem Vorteil ist aber, daß Lagetoleranzen zwischen Kontaktstift und Lötauge von untergeordneter Bedeutung sind, weil der Kontaktstift an beliebiger Stelle innerhalb der Fläche des Lötauges durchtreten kann. Auch bei außermittig im Lötauge angeordnetem Kontaktstift läßt sich eine sichere Lötverbindung herstellen.

Mit dem in Anspruch 2 gekennzeichneten Gerät lassen sich erhebliche Fertigungs- und Montagevorteile erzielen, weil ein Stanzloch in den Lötaugen entbehrlich ist und relativ große Lagetoleranzen zwischen den Kontaktstiften sowie den Lötaugen der Leiterbahnfolie zugelassen werden können. Außerdem wird durch die Maßnahme nach Anspruch 3 eine verringerte Beanspruchung der Kontaktstifte und der Leiterbahnfolie beim Fügevorgang erzielt, weil derart ausgebildete Kontaktstifte einen geringen Eindringwiderstand hervorrufen, mit einer schrägen Schneidkante einen ziehenden Schnitt erzeugen und ein Reißen der Leiterbahnfolie vermeiden.

Dieser Fügevorgang ist in vorteilhafter Weise unter Verwendung der im Anspruch 4 gekennzeichneten Vorrichtung ausführbar, welche die Handhabung der Leiterbahnfolie von der Aufnahme z. B. aus einem Magazin bis zum Verbinden mit dem elektrischen Bauteil erleichtert. Dabei wird durch die Ausgestaltung gemäß Anspruch 5 auf einfache Weise eine sichere Zuordnung der Lötaugen der Leiterbahnfolie zu den Kontaktstiften des elektrischen Bauteils erzielt. Damit beim Fügen eine unzulässigen Belastung der flexiblen Leiterbahnfolie vermieden wird, ist entsprechend der Weiterbildung nach Anspruch 6 eine Maßnahme getroffen, die ein Einziehen der Lötaugen in die Ausnehmungen der Platte vermeidet.

### Zeichnung

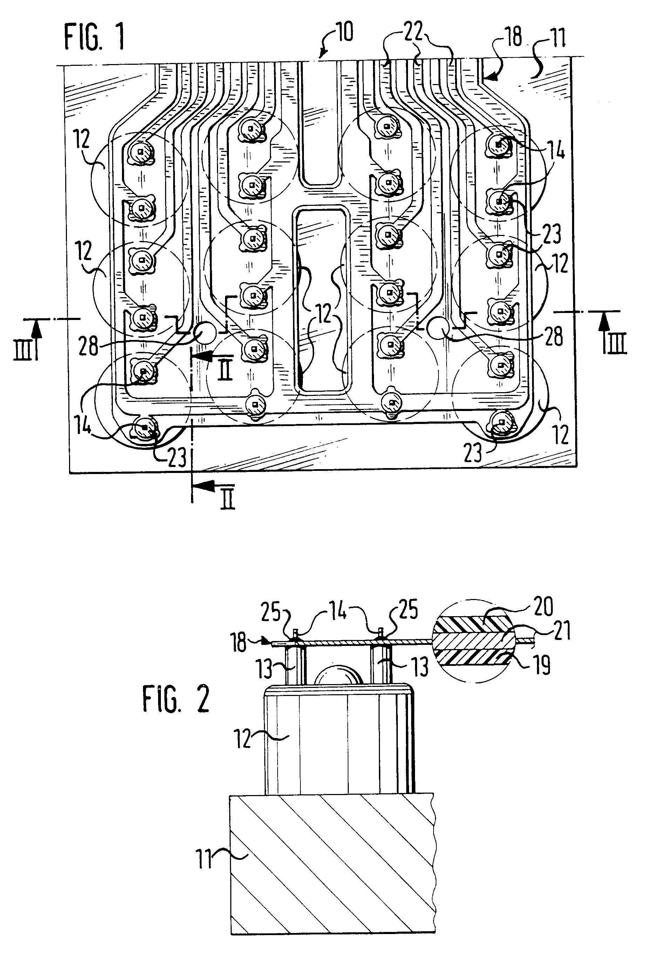

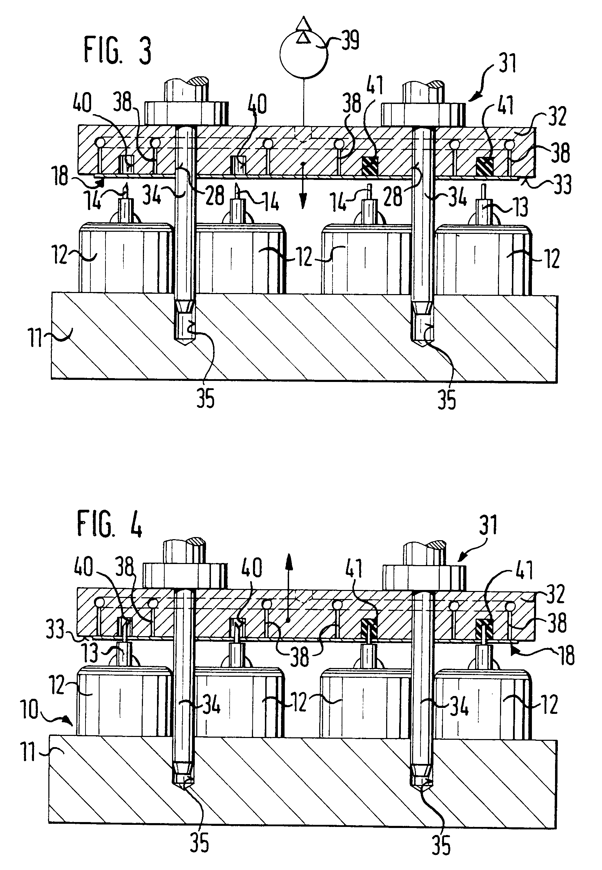

Ein erfindungsgemäßes Verfahrensbeispiel zur Erzeugung eines mehrere elektrische Bauteile und eine Leiterbahnfolie aufweisenden Gerätes unter Verwendung einer Vorrichtung zum Montieren der Leiterbahnfolie ist anhand der Zeichnung in der nachfolgenden Beschreibung näher erläutert. Es zeigen Figur 1 eine Draufsicht auf das Gerät mit elektrischen Bauteilen und montierter Leiterbahnfolie, Figur 2 einen Schnitt durch das Gerät entlang der Linie II-II in Figur 1 in anderem Maßstab sowie mit vergrößertem Querschnitt der Leiterbahnfolie als Detail, Figur 3 einen Schnitt durch das Gerät entlang der Linie III-III in Figur 1 mit einer gleichfalls geschnittenen Montagevorrichtung für die Leiterbahnfolie in einer Stellung kurz vor dem Fügen der Folien mit den elektrischen Bauteilen des Geräts und Figur 4 einen Schnitt entsprechend Figur 3 mit gefügter Leiterbahnfolie.

### Beschreibung des Ausführungsbeispiels

In den Figuren 1 und 2 ist ein Gerät 10, z. B. ein Ventilblock für eine hydraulische Fahrzeug-Bremsanlage mit Blockierschutz- und Antriebsschlupfregeleinrichtung, dargestellt, welches ein Gehäuse 11 mit mehreren Reihen darin befestigter elektrischer Bauteile 12, z. B. Magnetventile, aufweist. Die nach oben aus dem Gehäuse 11 herausragenden elektrischen Bauteile 12 sind oberseitig mit zwei Stützhülsen 13 versehen, aus denen jeweils ein Kontaktstift 14 mehrere Millimeter lang herausragt. Die Kontaktstifte 14 haben quadratischen Querschnitt mit einer Kantenlänge von weniger als 1 Millimeter. Die sich senkrecht zur Ebene des Gehäuses 11 erstreckenden Kontaktstifte 14 verlaufen parallel zueinander und enden in einer Ebene. Sie sind entsprechend der Anordnung der elektrischen Bauteile 12 ebenfalls in Reihen angeordnet.

Für die Kontaktierung der elektrischen Bauteile 12 ist eine flexible Leiterbahnfolie 18 vorgesehen. Wie das Detail in Figur 2 erkennen läßt, ist die Leiterbahnfolie 18 aus einer unteren Isolierschicht 19 und einer oberen Isolierschicht 20 mit einer dazwischenliegenden Leitschicht 21 aufgebaut. Die eine Verbindung zwischen den einzelnen Schichten herstellende Kleberschicht ist dabei vernachlässigt. Die beiden Isolierschichten 19 und 20 bestehen aus einem hochwärmebeständigen Kunststoff, z. B. Polyimid. Die Leitschicht 21 besteht aus Kupfer. Die gesamte Dicke der Leiterbahnfolie 18 beträgt etwa ein Zehntel Millimeter. Die Leitschicht 21 ist zu Leiterbahnen 22 ausgebildet welche kontaktstiftseitig in einem Lötauge 23 enden. Ein Lötauge 23 stellt eine kreisförmige Erweiterung der Leiterbahn 22 dar. Im Bereich des Lötauges 23 ist die obere Isolierschicht 20 in einer Fläche von vier Millimeter Durchmesser entfernt, d. h. im Bereich des Lötauges 23 besteht die Leiterbahnfolie 18 lediglich aus der unteren Isolierschicht 19 und der Leitschicht 21 mit zwischen beiden verlaufender Kleberschicht.

Die Leiterbahnfolie 18 ist auf die Kontaktstifte 14 der elektrischen Bauteile 12 bis zur Anlage an den Stützhülsen 13 aufgesteckt. Die untere Isolierschicht 19 und die Leitschicht 21 der Lötaugen 23 sind dabei von den Kontaktstiften 14 durchstochen, welche sich rechtwinklig zur Leiterbahnfolie 18 erstrecken. Die Leitschicht 21 der Lötaugen 23 steht somit spaltfrei mit den Kontaktstiften 14 der elektrischen Bauteile 12 in Verbindung. Zwar sind in Figur 1 die Kontaktstifte 14 in mittiger Lage zu den Lötaugen 23 dargestellt; die Kontaktstifte 14 können jedoch auch außermittig an beliebiger Stelle innerhalb des von der oberen Isolierschicht 20 freien Bereichs der Lötaugen 23 gelegen sein. Die Leiterbahnfolie 18 vermag daher aufgrund dieser Gestaltung der Lötaugen 23 Lagetoleranzen der elektrischen Bauteile und ihrer Kontaktstifte 14 aufzufangen.

Die Lötaugen 23 der Leiterbahnfolie 18 sind mit den Kontaktstiften 14 der elektrischen Bauteile 12 durch Lot 25 verbunden. Das Lot 25 benetzt den gesamten, von der oberen Isolierschicht 20 freien Bereich der Leitschicht 21 innerhalb des entsprechenden Lötauges 23 sowie den jeweiligen Kontaktstift 14.

Schließlich ist die Leiterbahnfolie 18 mit zwei Zentrierlöchern 28 versehen, deren Funktion später beschrieben wird.

Das Fügen der Leiterbahnfolie 18 mit den die Kontaktstifte 14 aufweisenden elektrischen Bauteilen 12 des Gerätes 10 wird in folgender Weise durchgeführt:

Es ist eine Vorrichtung 31 zum Montieren einer Leiterbahnfolie 18 vorgesehen (Figuren 3 und 4). Die Montagevorrichtung 31 hat eine Platte 32 mit einer unteren Seitenfläche 33, deren Ausdehnung die flächige Ausdehnung der Leiterbahnfolie 18 übersteigt. Mit der Platte 32 sind zwei sich senkrecht zur Seitenfläche 33 erstreckende Zentrierstifte 34 verbunden. Die Zentrierstifte 34 sind in einem Abstand angeordnet der dem Abstand der beiden Zentrierlöcher 28 in der Leiterbahnfolie 18 entspricht. Außerdem sind die Zentrierstifte 34 auf den Durchmesser der Zentrierlöcher 28 abgestimmt. Da die Montagevorrichtung 31 mit den Zentrierstiften 34 zum Eingriff in das Gehäuse 11 des Gerätes 10 bestimmt ist, weist das Gehäuse 11 entsprechend angeordnete und bemessene Positionierbohrungen 35 auf.

Die Platte 32 besitzt in ihrer Seitenfläche 33 eine Vielzahl von Saugöffnungen 38, welche mit einer Unterdruckquelle 39 in Verbindung stehen. Die Saugöffnungen 38 sind innerhalb des Teiles der Seitenfläche 33 angeordnet, welcher der aufzunehmenden Leiterbahnfolie 18 zugeordnet ist. In der Platte 32 sind ferner zur Seitenfläche 33 offene Ausnehmungen 40 in Form von Sacklochbohrungen vorgesehen. Diese sind in einer der Zahl der Kontaktstifte 14 der elektrischen Bauteile 12 entsprechenden Anzahl und Lagezuordnung vorgesehen und haben eine Tiefe, welche mindestens der freien Länge der Kontaktstifte 14 entspricht. Der Durchmesser der Ausnehmungen 40 ist der gleiche wie der von der oberen Isolierschicht 20 freie Bereich der Lötaugen 23. In der linken Hälfte der Figur 3 enthalten die Ausnehmungen 40 keine Füllung; in der rechten Hälfte der Figur 3 sind in den Ausnehmungen 40 Füllkörper 41 aus einem elastomeren Werkstoff aufgenommen.

Die Leiterbahnfolien 18 sind zweckmäßigerweise in einem Magazin deckungsgleich gestapelt. Die Lötaugen 23 der Leiterbahnfolien 18 weisen kein Stanzloch oder sonstige Durchbrechung auf. Die Montagevorrichtung 31 wird über das Magazin gebracht und abgesenkt, so daß die Zentrierstifte 34 die Zentrierlöcher 28 der Leiterbahnfolien 18 durchdringen. Durch Anlegen von Unterdruck wird die oberste Leiterbahnfolie 18 vom Stapel aufgenommen und an der Seitenfläche 33 der Platte 32 gehalten. Anschließend wird die Montagevorrichtung 31 über das mit den elektrischen Bauteilen 12 versehene Gerät 10 bewegt und abgesenkt. Dabei greifen die Zentrierstifte 34 der Montagevorrichtung 31 in die Positionierbohrungen 35 des Gehäuses 11 ein, bevor die Kontaktstifte 14 die Leiterbahnfolie 18 berühren. Durch das Zusammenwirken der Zentrierstifte 34 mit den Zentrierlöchern 28 der Leiterbahnfolie 18 einerseits und mit den Positionierbohrungen 35 des Gerätes 10 andererseits wird eine lagerichtige Zuordnung der Lötaugen 23 zu den Kontaktstiften 14 beim Absenken der Montagevorrichtung 31 erzielt. Im Verlauf der Absenkbewegung durchstechen die Kontaktstifte 34 die unterseitige Isolierschicht 19 und die Leitschicht 21 im von der oberen Isolierschicht 20 freien Bereich der Lötaugen 23. Um das Durchstechen zu erleichtern, können die Kontaktstifte 14 an ihrem freien Ende angespitzt oder endseitig schräg zu ihrer Längsachse abgeschert sein, z. B. in Form einer meißelförmigen Schneide mit schräg zur Längsachse verlaufender Schneidkante (erster Kontaktstift bzw. zweiter Kontaktstift von links in Figur 3). Beim weiteren Niederdrücken der Leiterbahnfolie 18 bis auf die Stützhülsen 13 der elektrischen Bauteile 12 dringen die Kontaktstifte 14 in den von den Ausnehmungen 40 gebildeten Freiraum ein. Sofern die Leiterbahnfolie 18 dem Durchstechen einen erhöhten Widerstand entgegensetzt und die Gefahr einer Beschädigung der Lötaugen 23 durch Einziehen in die Ausnehmungen 40 besteht, kann dies durch die Füllkörper 41 verhindert werden. Die Füllkörper 41 lassen ein Eindringen der Kontaktstifte 14 zu, nicht jedoch der Leiterbahnfolie 18.

Nach erfolgtem Fügevorgang wird die Unterdruckquelle 39 abgeschaltet und die Montagevorrichtung 31 vom Gerät 10 abgehoben. Die von der Montagevorrichtung 31 freigegebene Leiterbahnfolie 18 behält aufgrund ihres innigen, spaltfreien Kontaktes der Lötaugen 23 mit den Kontaktstiften 14 ihre Lagezuordnung zum Gerät 10. Diese form- und kraftschlüssige Verbindung zwischen der Leiterbahnfolie 18 und dem Gerät 10 macht Maßnahmen zur Lagesicherung der Leiterbahnfolie 18 bei der weiteren Handhabung des Gerätes 10 bis zum Erzeugen der Lötverbindung zwischen den Lötaugen 23 und den Kontaktstiften 14 entbehrlich. Das Aufbringen des Lotes 25 kann entweder durch Einzellötung oder durch Schwallbadlötung erfolgen, bei der das Gerät 10 mit nach unten gerichteter Leiterbahnfolie 18 gewendet ist.

## Patentansprüche

1. Verfahren zum Fügen einer Leiterbahnfolie (18) aus einer zwischen einer unteren und einer oberen Isolierschicht (19, 20) eingebetteten Leitschicht (21) mit wenigstens einem Kontaktstifte (14) aufweisenden elektrischen Bauteil (12), wobei die parallel zueinander verlaufenden Kontaktstifte (14) sich rechtwinklig zur Leiterbahnfolie (18) erstrecken, in einer Ebene enden und die Leiterbahnfolie (18) innerhalb von Lötaugen (23) durchgreifen, die auf ihrer gegen das Ende der Kontaktstifte (14) gerichteten, von einer Isolierschicht (20) freien Seite durch ein Lot (25) mit den Kontaktstiften (14) verbunden sind, gekennzeichnet durch die Verfahrensschritte:
- die Leiterbahnfolie (18) wird von einer Montagevorrichtung (31) aufgenommen,
- die Leiterbahnfolie (18) wird lagerichtig auf das elektrische Bauteil (12) abgesenkt,
- die unterseitige Isolierschicht (19) und die Leitschicht (21) der Lötaugen (23) werden von den Kontaktstiften (14) durchstochen,
- die Leiterbahnfolie (18) wird von der Montagevorrichtung (31) freigegeben,
- die Lötverbindung zwischen den Lötaugen (23) und den Kontaktstiften (14) wird hergestellt.

2. Gerät (10), welches nach dem Verfahren nach Anspruch 1 herstellbar ist, mit wenigstens einem parallel zueinander verlaufende Kontaktstifte (14) aufweisenden elektrischen Bauteil (12), mit einer Leiterbahnfolie (18) aus einer zwischen einer unteren und einer oberen Isolierschicht (19, 20) eingebetteten Leitschicht (21), mit die Kontaktstifte (14) umgreifenden Lötaugen sowie mit einer Lötverbindung zwischen der gegen das Ende der Kontaktstifte gerichteten, von einer Isolierschicht freien Seite der Lötaugen (23) und den Kontaktstiften (14), wobei die Kontaktstifte sich rechtwinklig zur Leiterbahnfolie (18) erstrecken und in einer Ebene enden, dadurch gekennzeichnet, daß die im Ausgangszustand ungelochten Lötaugen (23) der Leiterbahnfolie (18) und die im Ausgangszustand ungelochte unterseitige Isolierschicht (19) von den Kontaktstiften (14) spaltfrei durchstochen sind.

3. Gerät nach Anspruch 2, dadurch gekennzeichnet, daß die Kontaktstifte (14) angespitzt oder endseitig mit einer schräg zu ihrer Längsachse verlaufenden Schneide versehen sind.

4. Vorrichtung (31) zum Montieren einer Leiterbahnfolie (18) auf ein Kontaktstifte (14) aufweisendes elektrisches Bauteil (12) nach dem Verfahren nach Anspruch 1,
gekennzeichnet durch eine Platte (32), deren dem Aufnehmen und Halten der Leiterbahnfolie (18) dienende Seitenfläche (33) mit an eine Unterdruckquelle (39) angeschlossenen Saugöffnungen (38) versehen ist, und die Zentrierstifte (34) aufweist zum Ausrichten und Lagefixieren der Leiterbahnfolie (18) relativ zur Platte (32) sowie der Platte (32) relativ zum elektrischen Bauteil (12), und die ferner in ihrer Seitenfläche (33) liegende Ausnehmungen (40) zur Aufnahme der die Leiterbahnfolie (18) beim Absenken auf das elektrische Bauteil (12) durchdringenden Kontaktstifte (14) hat.

5. Vorrichtung nach Anspruch 4, dadurch gekennzeichnet, daß an der Platte (32) wenigstens zwei Zentrierstifte (34) für den Durchgriff durch Zentrierlöcher (28) der Leiterbahnfolie (18) und für den Eingriff in wenigstens mittelbar mit dem elektrischen Bauteil (12) in Verbindung stehende Positionierbohrungen (35) vorgesehen sind.

6. Vorrichtung nach Anspruch 4, dadurch gekennzeichnet, daß in den Ausnehmungen (40) der Platte (32) je ein elastomerer Füllkörper (41) aufgenommen ist.

## Claims

1. Method for connecting a printed circuit film (18), made from a conducting layer (21) embedded between a lower and an upper insulating layer (19, 20), to at least one electric component (12) which has contact pins (14), the contact pins (14), which run parallel to one another, extending at right angles to the printed circuit film (18), ending in a plane, and penetrating the printed circuit film (18) inside soldering eyes (23) which are connected to the contact pins (14) by a solder (25) on their side directed towards the end of the contact pins (14) and free from an insulating layer (20), characterized by the method steps:
- the printed circuit film (18) is picked up by a mounting device (31),
- the printed circuit film (18) is lowered in the correct position onto the electric component (12),
- the insulating layer (19) on the lower side and the conducting layer (21) of the soldering eyes (23) are pierced by the contact pins (14),
- the printed circuit film (18) is released by the mounting device (31), and
- the soldered connection between the soldering eyes (23) and the contact pins (14) is produced.

2. Apparatus (10) which can be produced according to the method according to Claim 1, comprising at least one electric component (12), which has contact pins (14) running parallel to one another, a printed circuit film (18) made from a conducting layer (21) embedded between a lower and an upper insulating layer (19, 20), soldering eyes surrounding the contact pins (14), and a soldered connection between the side of the soldered eyes (23), which is directed towards the end of the contact pins and free from an insulating layer, and the contact pins (14), the contacts pins extending at right angles to the printed circuit film (18) and ending in a plane, characterized in that the soldering eyes (23), which are unperforated in the initial state, of the printed circuit film (18) and the insulating layer (19) on the underside, which is unperforated in the initial state, are pierced by the contact pins (14) without a gap.

3. Apparatus according to Claim 2, characterized in that the contact pins (14) are provided in a pointed fashion or at the end with a cutting edge running obliquely relative to their longitudinal axis.

4. Device (31) for mounting a printed circuit film (18) on an electric component (12) which has contact pins (14), according to the method according to Claim 1, characterized by a plate (32) whose lateral surface (33), which serves to pick up and hold the printed circuit film (18), is provided with suction openings (38) which are connected to a low-pressure source (39), and which has centring pins (34) for aligning and fixing the position of the printed circuit film (18) relative to the plate (32) as well as of the plate (32) relative to the electric component (12), and which has, furthermore, recesses (40) situated in its lateral surface (33) for receiving the contact pins (14) which penetrate the printed circuit film (18) when it is lowered onto the electric component (12).

5. Device according to Claim 4, characterized in that there are provided on the plate (32) at least two centring pins (34) for penetration through centring holes (28) of the printed circuit film (18) and for engagement in positioning bores (35) which are at least indirectly connected to the electric component (12).

6. Device according to Claim 4, characterized in that an elastomeric filler (41) is held in each case in the recesses (40) of the plate (32).

## Revendications

1. Procédé pour connecter une plaquette à circuit imprimé (18) se composant d'une couche conductrice (21) incorporée entre une couche isolante inférieure et une couche isolante supérieure (19, 20) avec au moins un composant électrique présentant une tige de contact (14), les tiges de contact (14) s'étendant parallèlement les unes aux autres se trouvant à angle droit par rapport à la plaquette à circuit imprimé (18), se terminant dans un plan et passant à travers la plaquette à circuit imprimé (18) à l'intérieur de points de soudure (23), qui sont reliés par un côté libéré de la couche isolante (20) au moyen d'une soudure (25) aux tiges de contact (14), procédé caractérisé par les étapes suivantes :
- la plaquette à circuit imprimé (18) est reçue par un dispositif de montage (31),
- la plaquette à circuit imprimé (18) est abaissée en position correcte sur le composant électrique (12),
- la couche isolante inférieure (19) et la couche conductrice (21) des points de soudure (23) sont percées par les tiges de contact (14),
- la plaquette à circuit imprimé (18) est libérée par le dispositif de montage (31),
- la liaison par soudure entre les points de soudure (23) et les tiges de contact (14) est effectuée.

2. Appareil (10), qui peut être réalisé selon le procédé conforme à la revendication 1, avec au moins un composant électrique (12) présentant des tiges de contact (14) s'étendant en parallèle les unes aux autres, avec une plaquette à circuit imprimé (18) se composant d'une couche conductrice (21) incorporée entre une couche isolante inférieure et une couche isolante supérieure (19, 20), avec des points de soudure entourant les tiges de contact (14) ainsi qu'avec une liaison par soudure entre le côté des points de soudure (23) dirigé vers l'extrémité des tiges de contact, libéré d'une couche isolante et les tiges de contact (14), tandis que les tiges de contact (14) s'étendent à angle droit par rapport à la plaquette à circuit imprimé (18) et se terminent dans un plan, caractérisé en ce que les points de soudure (23), qui ne sont pas troués au départ de la plaquette à circuit imprimé (18) et la couche isolante (19) située du côté inférieur qui n'est pas trouée au départ sont percées par les tiges de contact (14) sans fente.

3. Appareil selon la revendication 2, caractérisé en ce que les tiges de contact (14) sont épointées ou sont pourvues du côté de leur extrémité d'un tranchant s'étendant obliquement par rapport à leur axe longitudinal.

4. Dispositif (31) servant à monter une plaquette à circuit imprimé (18) sur un composant électrique (12) présentant une tige de contact (14), selon le procédé conforme à la revendication 1, caractérisé par une plaque (32) dont la face latérale (33) servant à recevoir et à maintenir la plaquette à circuit imprimé (18) est pourvue d'ouvertures d'aspiration (38) raccordées à une source de dépression (39) et présente des broches de centrage (34) servant à diriger et à fixer en position la plaquette à circuit imprimé (18) par rapport à la plaque (32) ainsi que la plaque (32) par rapport au composant électrique (12) et qui a en outre des évidements (40) se trouvant dans sa surface latérale (33) qui servent à recevoir les tiges de contact (14) qui passent à travers la plaquette à circuit imprimé (18) lors de son abaissement sur le composant électrique (12).

5. Dispositif selon la revendication 4, caractérisé en ce que dans la plaque (32), sont prévues au moins deux broches de centrage (34) pour le passage à travers des trous de centrage (28) de la plaquette à circuit imprimé (18) et pour la venue en prise dans des perçages de positionnement (35) se trouvant en liaison au moins indirectement avec le composant électrique (12).

6. Dispositif selon la revendication 4, caractérisé en ce que dans les évidements (40) de la plaque (32) on place respectivement un corps de remplissage élastomère (41).
